# EUROPÄISCHE PATENTSCHRIFT

(11) **EP 3 180 827 B1**
(45) Veröffentlichungstag und Bekanntmachung des Hinweises auf die Patenterteilung: **03.04.2019**
(21) Anmeldenummer: 15735859.9
(22) Anmeldetag: 10.07.2015
(51) Int. Cl.: H02H 1/00, G01R 31/00, B60R 16/02, G01R 31/02

(54) **SCHALTUNGSANORDNUNG UND VERFAHREN ZUR ERKENNUNG EINES LICHTBOGENS IN EINEM KRAFTFAHRZEUG**
CIRCUIT ARRANGEMENT AND METHOD FOR DETECTING AN ARC IN A MOTOR VEHICLE
DISPOSITIF DE COMMUTATION ET PROCÉDÉ POUR LA DÉTECTION D'UN ARC ÉLECTRIQUE DANS UN VÉHICULE AUTOMOBILE

(30) Priorität: 12.08.2014 DE 102014012014
(43) Veröffentlichungstag der Anmeldung: 21.06.2017
(73) Patentinhaber: Audi AG, 85045 Ingolstadt (DE)
(72) Erfinder: OBERTHÜR, Jan, 85055 Ingolstadt (DE); PICKL, Alexander, 85049 Ingolstadt (DE)
(74) Vertreter: Herbst, Matthias Heinz
(86) Internationale Anmeldenummer: PCT/EP2015/001422
(87) Internationale Veröffentlichungsnummer: WO 2016/023606

(56) Entgegenhaltungen:
- WO-A2-01/24337
- DE-A1- 3 141 374
- DE-A1-102004 057 119
- US-A1- 2010 072 352

## Beschreibung

Die Erfindung betrifft eine Schaltungsanordnung zur Erkennung eines Lichtbogens in einem Kraftfahrzeug gemäß dem Oberbegriff des Patentanspruchs 1. Überdies betrifft die Erfindung ein Verfahren zum Betrieb einer derartigen Schaltungsanordnung. Schließlich betrifft die Erfindung ein Kraftfahrzeug mit einer derartigen Schaltungsanordnung.

Kraftfahrzeuge, insbesondere Elektrofahrzeuge oder Hybridfahrzeuge, umfassen ein Bordspannungsnetz, welches beispielsweise durch ein 12-Volt-Netz repräsentiert sein kann. Im Zuge dieses technischen Fortschritts gewinnt dabei das 48-Volt-Bordnetz immer mehr an Bedeutung. Bedingt durch die höhere Spannung steigt hierbei auch die Gefahr der Zündung eines Lichtbogens, welcher an den entsprechenden Stellen eine Schädigung der Betriebsmittel zur Folge hat.

Derzeit wird die 48-Volt-Technik für die Verwendung in Kraftfahrzeugen entwickelt. Stand der Technik ist, dass die zuverlässige Erkennung von parallelen Lichtbögen im Betrieb nicht möglich ist. Die im Kraftfahrzeug zu erwartenden Beschädigungen im 48-Volt-Bordnetz durch Alterung, Verschleiß und Beschädigung können zu parallelen Lichtbögen im Fahrzeug führen.

In diesem Zusammenhang offenbart die DE 103 33 674 A1 ein Lichtbogenüberwachungssystem in einem Bordnetz, bei dem Mittel zur Erkennung und Unterbrechung von an Verbindungsleitungen und Verbindungselementen in Spannungskreisen auftretenden seriellen Lichtbögen vorgesehen sind.

Überdies ist aus der DE 10 2004 057 119 A1 ein Verfahren zum Betreiben eines Stromkreises, insbesondere eines Kraftfahrzeugbordnetzes, beim Auftreten von Lichtbögen bekannt, wobei mittels einer Anordnung zum Erkennen von Lichtbögen der Stromkreis auf das Auftreten von Lichtbögen überwacht wird und wobei mittels eines Schaltmittels der Stromkreis abgeschaltet werden kann, falls ein Lichtbogen von der Anordnung erkannt worden ist. Dabei ist vorgesehen, dass das Schaltmittel im Falle des Erkennens des Auftretens eines Lichtbogens den Stromkreis kurzzeitig, z. B. für einen Bruchteil einer Sekunde, unterbricht, d. h. ausschaltet und selbsttätig wieder einschaltet.

Die DE 10 2010 053 816 A1 offenbart eine Vorrichtung zum Erkennung eines Lichtbogens in einem Bordnetz eines Kraftfahrzeugs, die zum Messen der Spannung und/oder des Stroms wenigstens eines Verbrauchers des Bordnetzes ausgebildet ist und ein Auswertemittel zum Erkennen ungewöhnlicher Messwerte der Spannung und/oder des Stroms aufweist, wobei die Vorrichtung zur Durchführung einer Spektrumanalyse ein Auftreten ungewöhnlicher Messwerte zum Erfassen breitbandiger Signale mittels eines Radioempfängers des Kraftfahrzeugs ausgebildet ist.

Aus der DE 10 2012 023 459 B3 ist ein Kraftfahrzeug-Bordnetz für ein Fahrzeug bekannt, umfassend: einen Netzbereich, der für eine Spannung ausgelegt ist, die über 16 V liegt, mehrere Komponentenpfade, in denen jeweils mindestens eine elektrische Komponente angeordnet ist, und wenigstens eine Lichtbogenüberwachungseinheit, wobei die elektrischen Komponenten wenigstens eine elektrische Komponente eines ersten Typs umfassen und wenigstens eine elektrische Komponente eines zweiten Typs, und die Lichtbogenüberwachungseinheit wenigstens ein Strommessmittel aufweist und dazu eingerichtet ist, ausgewählte oder sämtliche elektrische Komponenten des ersten Typs abzuschalten und eine Strommessung mit dem Strommessmittel in dem Komponentenpfad durchzuführen, in dem die entsprechende elektrische Komponente angeordnet ist, wenn die entsprechende elektrische Komponente abgeschaltet ist, eine Strommessung mit dem Strommessmittel in wenigstens einem Komponentenpfad durchzuführen, in dem eine elektrische Komponente des zweiten Typs angeordnet ist, wenn die entsprechende elektrischen Komponente im Betrieb ist, und einen Lichtbogen auf Grundlage des mit dem Strommessmittel gemessenen Stroms zu erkennen.

Die DE 94 17 398 U1 offenbart einen Lichtbogendetektor bestehend aus mindestens einem UV-empfindlichen Sensorelement, insbesondere zur Erkennung von Störlichtbögen in Anlagen, vorzugsweise Niederspannungsschaltanlagen, wobei das Sensorelement ein auf UV-Strahlung reagierendes Element ist, der sein Empfindlichkeitsmaximum im Bereich der UVB-Strahlung aufweist.

Aus der WO 01/24337 A2 ist eine elektrische Schaltung zur Erkennung eines Fehlerlichtbogens in einer elektrischen Schalteinrichtung bekannt. Zu diesem Zweck wird eine Schaltung umfassend einen Lichtdetektor bereitgestellt, welcher ein Lichtdetektorsignal als Antwort auf die erfasste Lichtmenge erzeugt. Ein Differentiations-Schaltkreis empfängt das Lichtdetektorsignal und differenziert das Lichtdetektorsignal über die Zeit, um ein abgeleitetes Lichtdetektorsignal zu erzeugen. Eine Komparatorschaltung vergleicht dann das abgeleitete Lichtdetektorsignal mit einem Referenzsignal und erzeugt ein Ausgangssignal, wenn das abgeleitete Lichtdetektorsignal das Referenzsignal überschreitet.

Die DE 31 41 374 A1 offenbart eine Anordnung zur Überwachung von elektrischen Einrichtungen auf die Ausbildung eines oder mehrerer Lichtbögen mit mindestens einem photoelektrischen Empfänger für den Empfang der Lichtbogenstrahlung, wobei an den Empfänger eine Differenzier- und Integrierschaltung angeschlossen ist, mit der ein Verstärker verbunden ist. Das auf dem jeweiligen Lichtbogen beruhende Ausgangssignal des Verstärkers ist nach einer die Dauer von betriebsmäßig auftretenden Lichtbögen übersteigenden Verzögerungszeit konjunktiv verknüpft mit einem vom Lichtbogen hervorgerufenen Ausgangssignal des photoelektrischen Empfängers an eine Auswertschaltung gelegt.

Die US 6,104,297 schlägt einen optischen Sensor zur Detektion einer Koronaentladung oder eines Lichtbogens an einem defekten Hochspannungskabel, Transformator oder Betriebsmittel vor. Nachteilig hierbei ist ein erheblicher schaltungstechnischer beziehungsweise Komponentenaufwand.

So muss beispielsweise bei einem optischen Sensor der natürliche UV-Anteil des Sonnenlichts aus der Auswertung ausgeblendet werden.

Es ist Aufgabe der vorliegenden Erfindung, für ein Kraftfahrzeug eine Schaltungsanordnung zur Lichtbogenunterdrückung bereitzustellen, welche eine einfache Struktur aufweist und zuverlässig funktioniert.

Diese Aufgabe wird durch eine Schaltungsanordnung mit den Merkmalen des Patentanspruchs 1, ein Kraftfahrzeug mit den Merkmalen des Patentanspruchs 9 und durch ein Verfahren mit den Merkmalen des Patentanspruchs 10 gelöst. Vorteilhafte Weiterbildungen der vorliegenden Erfindung sind Gegenstand der abhängigen Ansprüche.

Diese Aufgabe wird gelöst durch eine Schaltungsanordnung zur Erkennung eines Lichtbogens in einem Kraftfahrzeug, welche ein Bordnetz mit einer Batterie und einem Verbraucher sowie ein Steuergerät zum Schalten der Batterie des Bordnetzes in Abhängigkeit eines Signals aufweist. Weiterhin umfasst die Schaltungsanordnung einen Detektor für ultraviolette Strahlung zur Bereitstellung eines Licht-Messsignals, welches mit einer Intensität einer im Falle eines Lichtbogens ausgesendeten ultravioletten Strahlung korreliert, wobei eine Auswerteeinheit zur dynamischen Auswertung des Lichtmesssignals dazu ausgelegt ist, in Abhängigkeit einer Änderungsrate des Licht-Messsignals ein Vorhandensein des Lichtbogens mittels des Signals an das Steuergerät zu signalisieren. Dabei wird das Vorhandensein des Lichtbogens erkannt, wenn bei dem durch den Detektor bereitgestellten Licht-Messsignal ein sprungförmiger Anstieg messbar ist, der eine Anstiegszeit in einem Bereich von 2 Millisekunden bis 40 Millisekunden aufweist.

Durch die dynamische Auswertung des Licht-Messsignals ist es auf besonders einfache Art und Weise möglich, ein durch einen Lichtbogen erzeugtes Licht-Messsignal von einem Umgebungslichtsignal zu unterscheiden. Mittels der Auswertung einer Änderungsrate des Licht-Messsignal ist es so beispielsweise möglich, den Zündmoment eines Lichtbogens im Motorraum eines Kraftfahrzeugs, welcher ein schnell variierendes Ereignis darstellt, von dem Öffnen der Motorhaube, was zu einer Einstrahlung von Ultraviolettlicht durch die natürliche Sonneneinstrahlung führen kann, zu unterscheiden. Das Auswerteprinzip wirkt auch einer Fehlererkennung durch Umgebungshelligkeitsschwankungen entgegen. Insbesondere kann für den Detektor ein einfaches, günstiges Sensorelement eingesetzt werden, da nur Änderungen ausgewertet werden und keine absolute Genauigkeit erforderlich ist.

Bei einem 48-Volt-Lichtbogen wird elektrische Energie in Wärme und Licht umgewandelt. Das Licht setzt sich spektral zu einem großen Teil aus UV-Wellenlängen zusammen. Die Intensität des Lichts ist dabei so hoch, dass durch Reflexion der komplette Bauraum (zum Beispiel Motorraum) des Fahrzeugs beleuchtet wird. Somit sind keine direkten Sichtlinien für die Detektion eines Lichtbogens erforderlich. Selbstverständlich können dennoch Reflektoren oder Spiegelelemente eingesetzt werden.

In einer vorteilhaften Weiterbildung ist die Auswerteinheit dazu ausgelegt, das Signal als ein von der Intensität des Licht-Messsignals abhängiges binäres Signal an das Steuergerät bereit zu stellen.

Dadurch kann direkt das Bordnetz von der Batterie abgetrennt werden, wodurch der Lichtbogen erlöscht.

Bevorzugt kann die Auswerteeinheit ein Hochpass-Filter aufweisen, welches dazu ausgelegt ist, bei der Auswertung des Licht-Messsignals einen Gleichanteil und vorbestimmte tiefe Frequenzanteile des Licht-Messsignals auszublenden. Dadurch werden vorteilhafterweise natürliche Störquellen ausgeblendet, beispielsweise das Öffnen einer Motorhaube, das Ausfahren aus einem Tunnel oder ähnlichem. Auch eine gleichbleibend hohe Hintergrundbeleuchtung durch natürliches UV-haltiges Sonnenlicht wirkt nicht störend.

In einer bevorzugten Ausführungsform kann die Auswerteeinheit dazu ausgelegt sein, das Vorhandensein des Lichtbogens mittels des Signals an das Steuergerät zu signalisieren, wenn der sprungförmige Anstieg eine Anstiegszeit in einem Bereich von 8 Millisekunden bis 25 Millisekunden aufweist.

Der beim Zünden des Lichtbogens typischerweise messbare Anstieg der Helligkeit an dem Detektor weist typischerweise eine Anstiegszeit in dem genannten Bereich auf.

Bevorzugt der Erfindung handelt es sich bei dem Bordnetz um ein 48-Volt-Bordnetz.

In einer bevorzugten Ausgestaltung kann die Schaltungsanordnung ein Lichtleitelement aufweisen, welches dazu ausgelegt ist, mindestens einen optisch für den Detektor nicht unmittelbar erfassbaren Raum an den Detektor optisch zu koppeln.

Hierdurch ergibt sich der Vorteil, dass beispielsweise auch hinter einer Verkleidung oder Abdeckung angeordnete Komponenten oder komplett in einem Gehäuse integrierte Bauteile ebenfalls überwacht werden können.

In einer vorteilhaften Weiterbildung kann das Lichtleitelement als Lichtleitfaser oder Bündel von Lichtleitfasern ausgebildet sein, wobei das Lichtleitelement dazu ausgelegt ist, parallel zu einem elektrischen Element des Bordnetzes in Form einer Leitung oder eines Kabels verlegt zu werden.

Hierdurch ergibt sich der Vorteil, dass auch bei Einsatz eines einzigen Detektors der Erfassungsbereich, in welchem ein Lichtbogen detektiert werden kann, deutlich ausgeweitet wird. So kann beispielsweise in Kabelkanälen oder Kabeltunneln parallel ein Lichtleitelement verlegt sein, welches eine Detektion entlang der gesamten Leitungslänge des Bordnetzes ermöglicht.

Bevorzugt kann das Lichtleitelement eine Einkoppelstruktur zur Einkopplung von Licht, insbesondere von ultraviolettem Licht, in das Lichtleitelement aufweisen.

Dadurch wird sichergestellt, dass von dem Lichtbogen abgestrahltes UV-Licht in den Lichtleiter hinein gelangt und bis zu dem Detektor geführt wird.

Bevorzugt kann ein Kraftfahrzeug eine derartige Schaltungsanordnung aufweisen, wodurch sich ein erfindungsgemäßes Kraftfahrzeug ergibt.

Ebenfalls Teil der Erfindung ist ein Verfahren zur Erkennung eines Lichtbogens in einem Kraftfahrzeug, welches ein Bordnetz mit einer Batterie und einen Verbraucher sowie ein Steuergerät zum Schalten der Batterie des Bordnetzes in Abhängigkeit eines Signals und einem Detektor für ultraviolette Strahlung zur Bereitstellung eines Licht-Messsignals, welches mit einer Intensität einer im Falle eines Lichtbogens ausgesendeten ultravioletten Strahlung korreliert. Gemäß dem Verfahren wird dabei in Abhängigkeit einer Änderungsrate des Licht-Messsignals eine Vorhandensein des Lichtbogens mittels des Signals an das Steuergerät signalisiert. Dabei wird das Vorhandensein des Lichtbogens erkannt, wenn bei dem durch den Detektor bereitgestellten Licht-Messsignal ein sprungförmiger Anstieg gemessen wird, der eine Anstiegszeit in einem Bereich von 2 Millisekunden bis 40 Millisekunden aufweist.

Die für die erfindungsgemäße Schaltungsanordnung beschriebenen Vorteile und Merkmale sowie Ausführungsformen gelten gleichermaßen für das erfindungsgemäße Verfahren und umgekehrt. Folglich können für Verfahrensmerkmale entsprechende Vorrichtungsmerkmale und umgekehrt vorgesehen sein.

Im Folgenden ist die Erfindung detaillierter anhand eines Ausführungsbeispiels und der Figuren erläutert. Es zeigt:
- Fig. 1: eine vereinfachte Darstellung eines Ausführungsbeispiels des erfindungsgemäßen Kraftfahrzeugs; und
- Fig. 2.: eine beispielhafte Messung von einem Strom- und einem Helligkeitsverlauf eines Lichtbogens im Kraftfahrzeug.

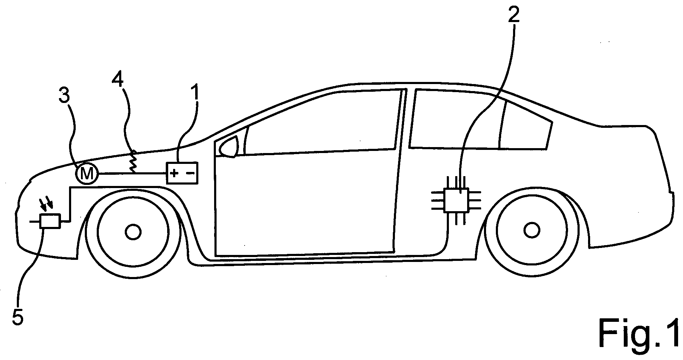

Fig. 1 zeigt eine Ausführungsform des erfindungsgemäßen Kraftfahrzeugs, welches eine Batterie 1 aufweist, die mit einem Verbraucher 3 elektrisch über eine Leitung gekoppelt ist, wobei der Verbraucher 3 beispielsweise ein Elektromotor sein kann. Die Batterie 1 und der Verbraucher 3 sind hier beispielhaft im Motorraum des Kraftfahrzeugs angeordnet, des Weiteren findet sich im Motorraum ein Detektor 5, welcher mit einem Steuergerät 2 elektrisch gekoppelt ist, welches hier bespielhaft im hinteren Teil des Kraftfahrzeugs angeordnet ist. Eine Auswerteeinheit zur dynamischen Auswertung des Licht-Messsignals des Detektors 5 kann bevorzugt auch in dem Steuergerät 2 integriert sein. Alternativ kann die Auswerteeinheit auch eine eigenständige Komponente sein, welche zwischen den Detektor 5 und das Steuergerät 2 gekoppelt ist. Beispielsweise kann nun an der Verbindungsleitung zwischen der Batterie 1 und dem Verbraucher 3 ein Lichtbogen entstehen, welcher zur Karosserie des Fahrzeugs hin brennt. Mittels des Detektors 5 wird die insbesondere im ultravioletten Bereich abgestrahlte Lichtemission in einen elektrischen Messwert umgeformt, welcher nachfolgend der Auswerteeinheit zur dynamischen Auswertung des Licht-Messsignals zugeführt wird. Dabei kann vorgesehen sein, dass die gemessene Lichtintensität des Lichtbogens 4 mit einem vorgebbaren Grenzwert verglichen wird, wobei bei einer Überschreitung des vorgebbaren Grenzwerts nachfolgend ein Signal an das Steuergerät 2 gesendet wird, welches dazu geeignet ist, in der Folge des Lichtbogens eine Abschaltung der Batterie 1 von dem Bordnetz herbeizuführen. Eine von dem Steuergerät 2 ansteuerbare Schaltvorrichtung ist in Fig. 1 nicht dargestellt.

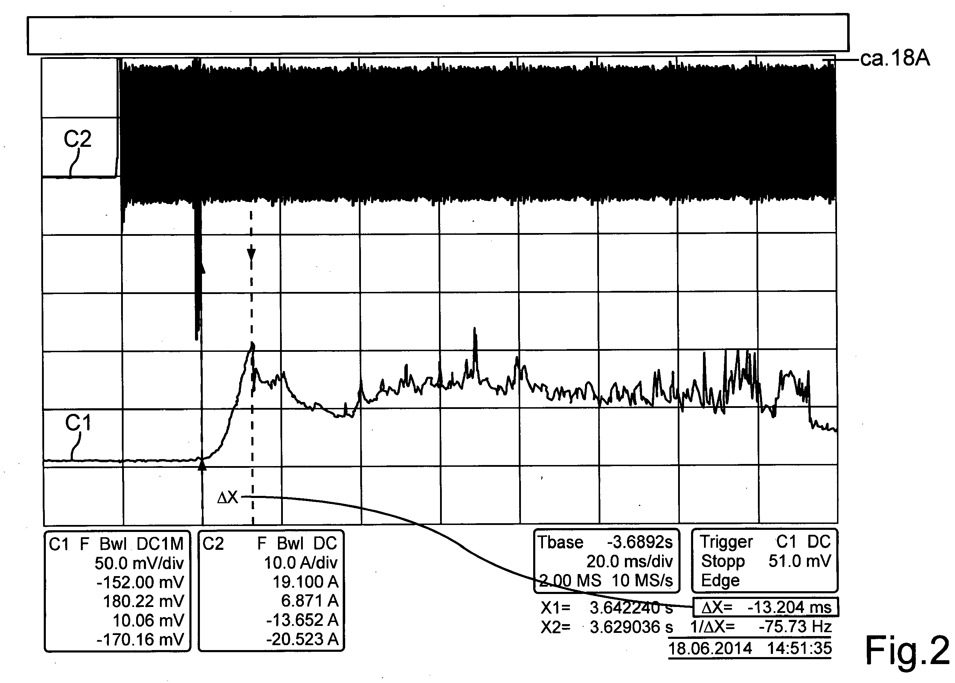

Fig. 2 zeigt eine vereinfachte oszillographische Aufnahme eines Lichtbogen-Brennstroms sowie eines elektrischen Messsignals, welches eine Helligkeit des von dem Lichtbogen ausgesendeten Lichts repräsentiert. Der stark oberwellenhaltige Brennstrom weist dabei einen Scheitelwert in Höhe von circa 18 Ampere auf. Das durch einen elektrischen Spannungsverlauf repräsentierte Helligkeitssignal zeigt eine Anstiegszeit von circa 13 Millisekunden. Nach der Zündphase zeigt das Helligkeitssignal des Lichtbogens einen deutlichen Oberwellengehalt, welcher bevorzugt mit einem Hochpass-Filter aus dem Signal extrahierbar ist, sodass hier eine zuverlässige Identifikation eines Lichtbogens möglich ist. Ohne das Vorhandensein eines Lichtbogens ist nur ein schwaches Rausch-Signal erkennbar.

Das Ausführungsbeispiel dient lediglich der Erläuterung der Erfindung und ist für diese nicht beschränkend. Insbesondere können die zuvor genannten Methoden und Merkmale zur Erfassung und Auswertung des Lichtbogens und dessen dynamischen Verhaltens beliebig miteinander kombiniert werden.

Insgesamt wurde so gezeigt, wie eine Lichtbogenerkennung per UV-Detektor im 48-Volt-Bordnetz mittels Auswertung von Helligkeitsgradienten realisiert sein kann.

## Patentansprüche

1. Schaltungsanordnung zur Erkennung eines Lichtbogens in einem Kraftfahrzeug, aufweisend:
- ein Bordnetz mit einer Batterie (1) und einem Verbraucher (3), und
- ein Steuergerät (2) zum Schalten der Batterie (1) des Bordnetzes in Abhängigkeit eines Signals,
**gekennzeichnet durch**
- einen Detektor (5) für ultraviolette Strahlung zur Bereitstellung eines Licht-Messsignals, welches mit einer Intensität einer im Falle eines Lichtbogens (4) ausgesendeten ultravioletten Strahlung korreliert, und
- eine Auswerteeinheit zur dynamischen Auswertung des Licht-Messsignals, welche dazu ausgelegt ist, in Abhängigkeit einer Änderungsrate des Licht-Messsignals ein Vorhandensein des Lichtbogens (4) mittels des Signals an das Steuergerät (2) zu signalisieren, wobei das Vorhandensein des Lichtbogens (4) erkannt wird, wenn bei dem durch den Detektor (5) bereitgestellten Licht-Messsignal ein sprungförmiger Anstieg messbar ist, der eine Anstiegszeit in einem Bereich von 2 Millisekunden bis 40 Millisekunden aufweist.

2. Schaltungsanordnung nach Anspruch 1,
**dadurch gekennzeichnet, dass**
die Auswerteeinheit dazu ausgelegt ist, das Signal als ein von der Intensität des Licht-Messsignals abhängiges binäres Signal an das Steuergerät (2) bereitzustellen.

3. Schaltungsanordnung nach einem der vorhergehenden Ansprüche,
**dadurch gekennzeichnet, dass**
die Auswerteeinheit ein Hochpass-Filter aufweist, welches dazu ausgelegt ist, bei der Auswertung des Licht-Messsignals einen Gleichanteil und vorbestimmte tiefe Frequenzanteile des Licht-Messsignals auszublenden.

4. Schaltungsanordnung nach einem der vorhergehenden Ansprüche,
**dadurch gekennzeichnet, dass**
die Auswerteeinheit dazu ausgelegt ist, das Vorhandensein des Lichtbogens (4) mittels des Signals an das Steuergerät (2) zu signalisieren, wenn der sprungförmige Anstieg eine Anstiegszeit in einem Bereich von 8 Millisekunden bis 25 Millisekunden aufweist.

5. Schaltungsanordnung nach einem der vorhergehenden Ansprüche,
**dadurch gekennzeichnet, dass**
es sich bei dem Bordnetz um ein 48-Volt-Bordnetz handelt.

6. Schaltungsanordnung nach einem der vorhergehenden Ansprüche,
**gekennzeichnet durch**
ein Lichtleitelement, welches dazu ausgelegt ist, mindestens einen optisch für den Detektor (5) nicht unmittelbar erfassbaren Raum mit hinter einer Verkleidung oder Abdeckung angeordneten Komponenten oder komplett in einem Gehäuse integrierten Bauteilen an den Detektor (5) optisch zu koppeln.

7. Schaltungsanordnung nach Anspruch 6,
**dadurch gekennzeichnet, dass**
das Lichtleitelement als Lichtleitfaser oder Bündel von Lichtleitfasern ausgebildet ist, wobei das Lichtleitelement dazu ausgelegt ist, parallel zu einem elektrischen Element des Bordnetzes in Form einer Leitung oder eines Kabels in Kabelkanälen oder Kabeltunneln verlegt zu werden.

8. Schaltungsanordnung nach Anspruch 6 oder 7,
**dadurch gekennzeichnet, dass**
das Lichtleitelement eine Einkoppelstruktur zur Einkopplung von Licht, insbesondere von ultraviolettem Licht, in das Lichtleitelement aufweist.

9. Kraftfahrzeug mit einer Schaltungsanordnung nach einem der vorhergehenden Ansprüche.

10. Verfahren zur Erkennung eines Lichtbogens in einem Kraftfahrzeug, welches ein Bordnetz mit einer Batterie (1) und einem Verbraucher (3) und ein Steuergerät (2) zum Schalten der Batterie (1) des Bordnetzes in Abhängigkeit eines Signals umfasst,
**dadurch gekennzeichnet, dass**
mittels eines Detektors (5) für ultraviolette Strahlung ein Licht-Messsignal, welches mit einer Intensität einer im Falle eines Lichtbogens (4) ausgesendeten ultravioletten Strahlung korreliert, bereitgestellt wird, wobei das Licht-Messsignal dynamisch ausgewertet wird, indem in Abhängigkeit einer Änderungsrate des Licht-Messsignals ein Vorhandensein des Lichtbogens (4) mittels des Signals an das Steuergerät (2) signalisiert wird, wobei das Vorhandensein des Lichtbogens (4) erkannt wird, wenn bei dem durch den Detektor (5) bereitgestellten Licht-Messsignal ein sprungförmiger Anstieg gemessen wird, der eine Anstiegszeit in einem Bereich von 2 Millisekunden bis 40 Millisekunden aufweist.

## Claims

1. Circuit arrangement for detecting an arc in a motor vehicle having:
- a vehicle electrical system with a battery (1) and a load (3), and
- a control device (2) for switching the battery (1) of the vehicle electrical system dependent on a signal,
**characterised by**
- an ultraviolet radiation detector (5) for providing a light measurement signal which correlates to an intensity of an ultraviolet radiation emitted in the event of an arc (4), and
- an evaluation unit for dynamically evaluating the light measurement signal, which is designed to signal a presence of the arc (4) by means of the signal to the control device (2) on the basis of a change of the light measurement signal, wherein the presence of the arc (4) is detected, if a sharp rise, having a rise time in a range from 2 milliseconds to 40 milliseconds, is measurable in the light measurement signal provided by the detector (5).

2. Circuit arrangement according to claim 1,
**characterised in that**
the evaluation unit is designed to provide the signal to the control device (2) as a binary signal dependent on the intensity of the light measurement signal.

3. Circuit arrangement according to any one of the preceding claims,
**characterised in that**
the evaluation unit has a high-pass filter, which is designed to mask a steady component and predetermined low frequency components of the light measurement signal during evaluation of the light measurement signal.

4. Circuit arrangement according to any one of the preceding claims,
**characterised in that**
the evaluation unit is designed to signal to the control device (2) the presence of the arc (4) by means of the signal, when the sharp rise has a rise time in a range from 8 milliseconds to 25 milliseconds.

5. Circuit arrangement according to any one of the preceding claims,
**characterised in that**
the vehicle electrical system is a 48-volt vehicle electrical system.

6. Circuit arrangement according to any one of the preceding claims,
**characterised by**
a light guide element, which is designed to couple optically onto the detector (5) at least one space optically not directly determinable for the detector (5) with components arranged behind a lining or cover or parts integrated completely in a housing.

7. Circuit arrangement according to claim 6,
**characterised in that**
the light guide element is formed as light guide fibre or bundle of light guide fibres, wherein the light guide element is designed to be laid parallel to an electrical element of the vehicle electrical system in the form of a line or a cable in cable ducts or cable conduits.

8. Circuit arrangement according to claim 6 or 7,
**characterised in that**
the light guide element has a coupling-in structure for the coupling-in of light, more particularly of ultraviolet light, into the light guide element.

9. Motor vehicle having a circuit arrangement according to any one of the preceding claims.

10. Method for detecting an arc in a motor vehicle having a vehicle electrical system with a battery (1) and a load (3) and a control device (2) for switching the battery (1) of the vehicle electrical system dependent on a signal,
**characterised in that**
a light measurement signal which correlates to an intensity of an ultraviolet radiation emitted in the event of an arc (4) is provided by means of an ultraviolet radiation detector (5), wherein the light measurement signal is dynamically evaluated through the signalling of the presence of the arc (4) to the control device (2), depending on a change in the light measurement signal (4), by means of the signal, wherein the presence of the arc (4) is detected, if a sharp rise, having a rise time in a range from 2 milliseconds to 40 milliseconds, is measured in the light measurement signal provided by the detector (5).

## Revendications

1. Dispositif de commutation pour la détection d'un arc électrique dans un véhicule automobile, présentant :
- un réseau de bord avec une batterie (1) et un consommateur (3), et
- un appareil de commande (2) pour la commutation de la batterie (1) du réseau de bord en fonction d'un signal,
**caractérisé par**
- un détecteur (5) pour rayonnement ultraviolet pour la mise à disposition d'un signal de mesure de lumière, lequel corrèle avec une intensité d'un rayonnement ultraviolet émis dans le cas d'un arc électrique (4), et
- une unité d'évaluation pour l'évaluation dynamique du signal de mesure de lumière, laquelle est conçue pour signaler, en fonction d'un taux de variation du signal de mesure de lumière, une présence de l'arc électrique (4) au moyen du signal à l'appareil de commande (2), dans lequel la présence de l'arc électrique (4) est détectée, lorsque une augmentation soudaine, qui présente un temps d'augmentation dans la plage de 2 millisecondes à 40 millisecondes, peut être mesurée pour le signal de mesure de lumière mis à disposition par le détecteur (5).

2. Dispositif de commutation selon la revendication 1,
**caractérisé en ce que**
l'unité d'évaluation est conçue pour mettre à disposition le signal en tant que signal binaire dépendant de l'intensité du signal de mesure de lumière à l'appareil de commande (2).

3. Dispositif de commutation selon l'une quelconque des revendications précédentes,
**caractérisé en ce que**
l'unité d'évaluation présente un filtre passe-haut, lequel est conçu pour masquer une composante continue et des composantes de fréquence profondes prédéterminées du signal de mesure de lumière lors de l'évaluation du signal de mesure de lumière.

4. Dispositif de commutation selon l'une quelconque des revendications précédentes,
**caractérisé en ce que**
l'unité d'évaluation est conçue pour signaler la présence de l'arc électrique (4) au moyen du signal à l'appareil de commande (2), lorsque l'augmentation soudaine présente un temps d'augmentation dans une plage de 8 millisecondes à 25 millisecondes.

5. Dispositif de commutation selon l'une quelconque des revendications précédentes,
**caractérisé en ce que**
le réseau de bord est un réseau de bord de 48 Volt.

6. Dispositif de commutation selon l'une quelconque des revendications précédentes,
**caractérisé par**
un élément de guidage de lumière, lequel est conçu pour coupler optiquement au détecteur (5) au moins un espace pouvant être détecté non directement de manière optique pour le détecteur (5) avec des composants agencés derrière un revêtement ou recouvrement ou des éléments de construction intégrés complètement dans un boîtier.

7. Dispositif de commutation selon la revendication 6,
**caractérisé en ce que**
l'élément de guidage de lumière est réalisé en tant que fibre optique ou faisceau de fibres optiques, dans lequel l'élément de guidage de lumière est conçu pour être posé parallèlement à un élément électrique du réseau de bord sous la forme d'une conduite ou d'un câble dans des conduits de câble ou tunnels de câble.

8. Dispositif de commutation selon la revendication 6 ou 7,
**caractérisé en ce que**
l'élément de guidage de lumière présente une structure d'injection pour l'injection de lumière, en particulier de lumière ultraviolette, dans l'élément de guidage de lumière.

9. Véhicule automobile avec un dispositif de commutation selon l'une quelconque des revendications précédentes.

10. Procédé de détection d'un arc électrique dans un véhicule automobile, lequel comprend un réseau de bord avec une batterie (1) et un consommateur (3) et un appareil de commande (2) pour la commutation de la batterie (1) du réseau de bord en fonction d'un signal,
**caractérisé en ce que**
un signal de mesure de lumière, lequel corrèle avec une intensité d'un rayonnement ultraviolet émis dans le cas d'un arc électrique (4), est mis à disposition au moyen d'un détecteur (5) pour rayonnement ultraviolet, dans lequel le signal de mesure de lumière est évalué dynamiquement, par le fait qu'une présence de l'arc électrique (4) est signalée au moyen du signal à l'appareil de commande (2) en fonction d'un taux de variation du signal de mesure de lumière , dans lequel la présence de l'arc électrique (4) est détectée, lorsqu'une augmentation soudaine, qui présente un temps d'augmentation dans la plage de 2 millisecondes à 40 millisecondes, est mesurée pour le signal de mesure de lumière mis à disposition par le détecteur (5).
